# EUROPÄISCHE PATENTSCHRIFT

(11) **EP 0 530 749 B1**
(45) Veröffentlichungstag und Bekanntmachung des Hinweises auf die Patenterteilung: **18.05.1994**
(21) Anmeldenummer: 92114929.0
(22) Anmeldetag: 01.09.1992
(51) Int. Cl.: H03L 7/07

(54) **Verfahren und Vorrichtung zur Synchronisation einer Takteinrichtung eines Fernmeldevermittlungssystems**
Method and apparatus for synchronising a clock-circuit of a switching communication system
Méthode et dispositif pour la synchronisation d'un générateur d'horloge d'un système de commutation de communication

(30) Priorität: 02.09.1991 EP 91114771; 18.09.1991 DE 4131063
(43) Veröffentlichungstag der Anmeldung: 10.03.1993
(73) Patentinhaber: SIEMENS AKTIENGESELLSCHAFT, 80333 München (DE)
(72) Erfinder: Oberhauser, Walter, Dipl.-Ing., W-8190 Wolfratshausen (DE); Hoffmann, Reinhold, Dr. rer. nat., W-8919 Utting (DE)

(56) Entgegenhaltungen:
- EP-A- 0 084 002
- EP-A- 0 423 663
- WO-A-87/00369
- DE-A- 3 809 089
- PATENT ABSTRACTS OF JAPAN, Bd. 13, Nr. 558 12. Dezember 1989;& JP-A-1231450
- IEEE COMMUNICATIONS MAGAZINE, Bd. 19, Nr. 3, Mai 1981, New York, US;Seiten 12- 21,KATSUYA OKIMI AND HIROSHI FUKINUKI:"Master-slave synchronisation techniques."
- PATENT ABSTRACTS OF JAPAN, Bd. 10, Nr. 384 (E-466)(2441) 23. Dezember 1986;& JP-A-61173600
- PATENT ABSTRACTS OF JAPAN, Bd. 13, Nr. 352 8. August 1989;& JP-A-1112838

## Beschreibung

Die Erfindung betrifft ein Verfahren nach dem Oberbegriff des Anspruchs 1.

In synchronen digitalen Fernmeldenetzen werden zentrale Takteinrichtungen der einzelnen digitalen Vermittlungsstellen hierarchisch nach dem master/slave-Prinzip synchronisiert. Dabei wird für das gesamte Netz ein einziger frequenzbestimmender Taktgenerator (masterclock) vorgesehen. Alle anderen Taktgeneratoren werden auf seine Taktfrequenz synchronisiert. Dieses Verfahren birgt allerdings vor allem für größere Netze die Gefahr in sich, daß ein Fehler im zentralen Taktgeber das gesamte Netz zum Ausfall bringt. Zur Reduzierung der Störwirkbreite werden daher bei diesem Verfahren redundante Taktversorgungsleitungen vorgesehen und auch relativ genaue örtliche Taktgeneratoren eingesetzt, damit im Fehlerfall wenigstens mit noch akzeptabler Schlupfrate der Betrieb aufrechterhalten werden kann. (Bergmann, Lehrbuch der Fernmeldetechnik, Band 1, 5. Auflage, Berlin 1986, Seite 485).

Aus der europäischen Patentanmeldung 90105379.3 ist bereits ein Verfahren zur Synchronisation einer Takteinrichtung eines getakteten elektrischen Systems bekannt. Die Fernmeldevermittlungsstelle wird im Normalbetrieb von einer externen Referenzfrequenz synchronisiert und bei längerem Ausfall der externen Referenzfrequenz wird ein systeminternes Frequenz-Normal eingeschaltet, welches von der Takteinrichtung räumlich getrennt ist. Ist mehr als eine externe Referenzfrequenz verfügbar, wird das systeminterne Frequenz-Normal nur dann aktiviert, wenn sämtliche externen Referenzfrequenzen ausgefallen sind. Bei Ausfall der momentan benutzten externen Referenzfrequenz wird auf eine andere externe Referenzfrequenz umgeschaltet. Dabei bleibt offen, in welcher Weise diese Umschaltung erfolgt, wenn bei Ausfall der momentan angeschalteten externen Referenzfrequenz quenz eine Mehrzahl weiterer externer Referenzfrequenzen verfügbar sind.

Aus der EP-A-0 423 663 ist eine Takteinrichtung bekannt, die Referenztaktsignale unterschiedlicher Priorität vorsieht. Ein Referenztaktsignal geringerer Priorität wird nur dann ausgewählt, wenn ein Taktsignal höherer Priorität eine vorgegebene Qualität unterschreitet.

Der Erfindung liegt die Aufgabe zugrunde, ein Verfahren zur Synchronisation einer Takteinrichtung eines digitalen Fernmeldevermittlungssystems anzugeben, welches bei Zufuhr einer Mehrzahl externer Referenzfrequenzen den Anforderungen an eine ausreichende Synchronisation soweit als möglich entspricht.

Diese Aufgabe wird bei einem Verfahren der eingangs genannten Art durch die kennzeichnenden Merkmale des Anspruchs 1 gelöst.

Eine Vorrichtung zur Durchführung der Verfahrens ist im Anspruch 7 augegeben.

Als wesentlich für die Erfindung ist anzusehen, daß die Auswahl einer von einer Mehrzahl externe Referenztaktquellen bzw. Referenztaktsignalen nach zwei unterschiedlichen Kriterien erfolgt; eine von der voraussehbaren Güte der Referenztaktquellen bzw. der entsprechenden Übertragungstrecke abhängige Priorität und von dem Auftreten von Fehlern im laufenden Betrieb.

Damit kann die momentan jeweils beste Referenztaktquelle für die Synchronisation der Takteinrichtung verwendet werden. Zugleich wird im Falle einer Erstinbetriebnahme des Fernmeldevermittlungssystems und im Falle einer Wiederinbetriebnahme in unterschiedlicher Weise verfahren: während bei einer Erstinbetriebnahme des Systems den Referenztaktquellen bzw. den Referenztaktsignalen vorgegebene, insbesondere gleiche Fehlerwerte zugeordnet werden, wird bei einer Wiederinbetriebnahme des Systems das Synchronisationsverfahren ausgehend von den zum Zeitpunkt des Systemausfalls vorliegenden aktuellen Fehlerwerten fortgesetzt. Hierdurch wird das erfindungsgemäße Synchronisationsverfahren nach einer Erstinbetriebnahme maßgeblich durch die vorgegebenen Prioritäten bestimmt, wobei die Synchronisation nach einer Erstinbetriebnahme in Abhängigkeit von den referenztaktsignalindividuellen Fehlern einen längeren Zeitraum beanspruchen kann, bis zu welchem die gewünschte Langzeitstabilität erreicht wird. Dagegen wird bei einer Wiederinbetriebnahme der bis zur Realisierung der Langzeitstabilität erforderliche Zeitraum auf beispielsweise wenige Sekunden erheblich abgekürzt, wenn nach einem Systemausfall, bei dem die zentrale Takteinrichtung mittels ihres weitgehend stabilen Oszilators die zum Zeitpunkt des Ausfalls vorliegende Referenzfrequenz noch über einen bestimmten Zeitraum halten kann und die Wiederinbetriebnahme des ausgefallenen Systemteils in diesem Zeitraum erfolgt. Die interne Frequenz stimmt dann mit dem externen Referenztaktsignal noch ausreichend genau überein; ein Synchronisationsvorgang wie bei einer Erstinbetriebnahme des Systems ist damit nicht erforderlich.

Nach einer weiteren vorteilhaften Ausführungsform der Erfindung ist vorgesehen, daß bei einer Wiederinbetriebnahme des Fernmeldevermittlungssystems, die nach Ablauf einer vorgegebenen Zeiteinheit nach dem Systemausfall erfolgt, die Synchronisation ausgehend von dem Anfangsfehlerwert neu begonnen wird. Damit kann einem geändertem Fehlerverhalten der Referenztaktquellen bzw. der Übertragungstrecken in geeigneter Weise entsprochen werden.

Nach einer weiteren vorteilhaften Ausführungsform der Erfindung ist vorgesehen, daß die Takteinrichtung zu ihrer Synchronisation nach der Erstinbetriebnahme und nach der Wiederinbetriebnahme bei gleichen Prioritäten der Referenztaktquellen das Referenztaktsignal mit geringerem taktfehlerindividuellen aktuellen Fehlerwert übernimmt, und daß die Takteinrichtung bei unterschiedlichen Prioritäten der Referenztaktquellen das Referenztaktsignal der Referenztaktquelle höchster Priorität übernimmt, sofern das von dieser Referenztaktquelle zugeführte Referenztaktsignal einen vorgegebebenen oberen ersten Fehlergrenzwert nicht überschreitet, und daß bei einem Überschreiten dieses Fehlergrenzwertes die Takteinrichtung das Referenztaktsignal der Referenztaktquelle nachgeordneter Priorität übernimmt, sofern das von der Referenztaktquelle nachgeordneter Priorität zugeführte Referenztaktsignal einen geringeren aktuellen Fehlerwert als das Referenztaktsignal der Referenztaktquelle höchster Priorität aufweist.

Damit bleibt das Referenztaktsignal höchster Priorität für die Synchronisation der Takteinrichtung maßgeblich, selbst wenn der aktuelle Fehlerwert des Referenztaktsignals höchster Priorität größer ist als der aktuelle Fehlerwert des Referenztaktsignals nachgeordneter Priorität, sofern das Referenztaktsignal höchster Priorität den vorgegebenen ersten Fehlergrenzwert nicht überschreitet. Auf diese Weise wird die Anzahl vorzunehmender Referenztaktwechsel sowohl nach einer Erstinbetriebnahme als auch nach einer Wiederinbetriebnahme vermindert. Damit entfallen Synchronisationsvorgänge, die je nach der Struktur des zugehörigen Fernmeldevermittlungssystems mehrere Minuten erfordern können, so daß durch die Ausführungsform der Erfindung die Langzeitstabilität des Systems verbessert wird.

Diese Vorteile ergeben sich auch, wenn die Takteinrichtung zu ihrer Synchronisation nach der Erstinbetriebnahme oder nach der Wiederinbetriebnahme des Fernmeldevermittlungssystems bei gleichen oder unterschiedlichen Prioritäten der Referenztaktquellen das von der momentan aktivierten Referenztaktquelle abgegebene Referenztaktsignal auch dann beibehält, wenn der aktuelle Fehlerwert dieses Referenztaktsignals unter einem unteren, zweiten Fehlergrenzwert liegt und der aktuelle Fehlerwert des oder der anderen Referenztaktsignale einen gleichen oder geringeren aktuellen Wert aufweisen.

Der Einfluß zeitlich zurückliegender Fehler wird dadurch verringert, daß die Fehlerwerte, die den der Takteinrichtung zugeführten Referenztaktsignalen zugeordet sind, nach Ablauf vorgegebener Zeiteinheiten ausschließlich etwaiger Ausfallzeiten um einen vorgegebenen Wert vermindern werden.

Weitere vorteilhafte Ausgestaltungen sind in den Unteransprüchen gekennzeichnet und werden im folgenden anhand der Figuren beschrieben.

Es zeigt
- Fig. 1: ein Blockschaltbild einer Takteinrichtung;
- Fig. 2: das Blockschaltbild einer Takteinrichtung an die in einem Fernmeldevermittlungssystem eine Mehrzahl referenztaktliefernder Baugruppen angeschaltet ist; und
- Fig. 3: ein Beispiel für den Inhalt eines Tabellenspeichers in einer Takteinrichtung nach Fig. 1 oder Fig. 2

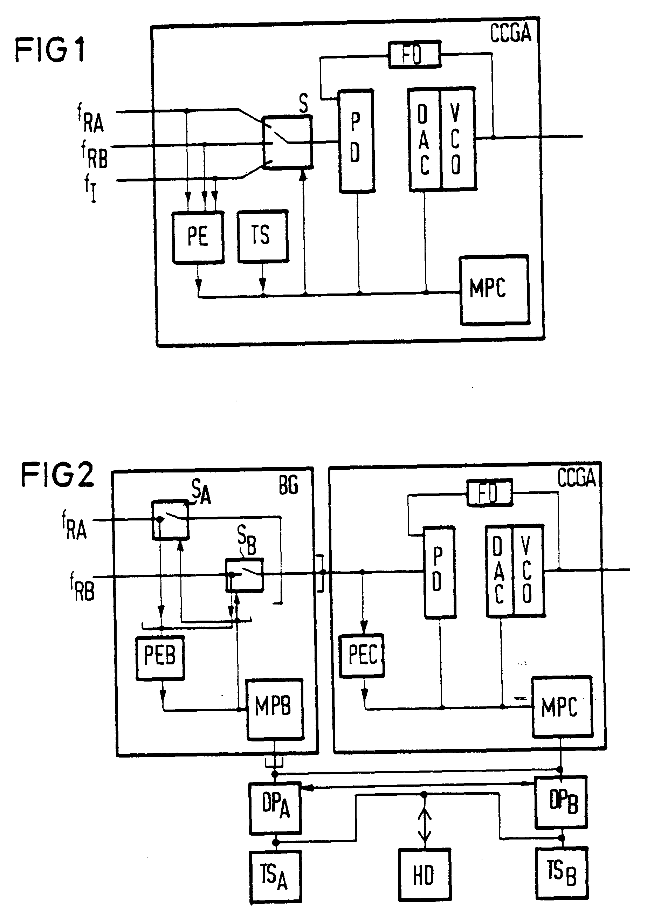

Anhand der in Figur 1 dargestellten Takteinrichtung wird nun das Synchronisierverfahren erläutert. Die in Figur 1 dargestellte Takteinrichtung, insbesondere eines Fernmeldevermittlungssystems, umfaßt einen zentralen Taktgenerator CCGA, dem beispielsweise zwei externe Referenzfrequenzen f_{RA} und f_{RB} von einer in Fig. 1 nicht dargestellten ersten Referenztaktquelle A und einer zweiten externen Referenztaktquelle B zugeführt werden. Zusätzlich kann dem zentralen Taktgenerator CCGA eine interne Referenzfrequenz fI zugeführt werden, die beispielsweise von einer systeminternen Taktquelle geliefert wird.

Die Eingänge des Taktgenerators CCGA sind durch einen von einem Mikroprozessor MPC gesteuerten Schalter S umschaltbar. Die die externen Referenztaktsignale führenden Eingänge des Taktgenerators sind mit einer Einrichtung PE verbunden, die wie noch beschrieben wird, die zugeführten Referenztaktsignale auf Taktfehler überprüft und den Taktfehlern individuelle Fehlerwerte zuordnet. Diese Fehlerwerte werden in dem Tabellenspeicher TS individuell für jedes externe Referenztaktsignal verwaltet. Zusätzlich können im Tabellenspeicher TS die Prioritätswerte für diejenigen externen Referenztaktquellen abgelegt sein, die die entsprechenden Referenztaktsignale dem zentralen Taktgenerator CCGA zuführen. Im vorliegenden Fall beträgt, der Prioritätswert der externen Referenztaktquelle A beispielsweise gleich 90 und der Prioritätswert der externen Referenztaktquelle B gleich 89.

Allen Referenztaktsignalen wird bei einer Erstinbetriebnahme des Fernmeldevermittlungssystems ein Anfangsfehlerwert zugeordnet. Insbesondere wird allen Referenztaktsignalen bei einer Erstinbetriebnahme derselbe Anfangsfehlerwert von beispielsweise 16000 zugeordnet. Der Anfangsfehlerwert ist insbesondere gleich einem unteren zweiten Fehlergrenzwert, der unten erläutert wird.

Der Mikroprozessor MPC steuert die Regelung des Phasenregelkreises, der im weiteren aus einem Phasendiskriminator PD, einem Digital-Analog-Converter DAC, einem spannungsgesteuerten Oszilator VCO und einer Rückführungsschleife FD besteht, die die Ausgangsfrequenz des spannungsgesteuerten Oszilators VCO auf einen Eingang des Phasendiskriminators PD zurückführt.

Der Mikroprozessor MPC steuert den Schalter S einerseits in Abhängigkeit von der Einrichtung PE ermittelten referenztaktsignalindividuellen Taktfehler bzw. der den Taktfehlern zugeordneten Fehlerwerte und andererseits in Abhängigkeit von der vorgegebenen Priorität der externen Referenztaktquellen A und B. Die Priorität der externen Referenztaktquellen wird entsprechend ihrer Taktgüte und der Qualität der Übertragungsstrecke von der jeweiligen Referenztaktquelle zum betrachteten zentralen Taktgenerator bestimmt. ISDN-Anschlüssen werden relativ hohe Prioritäten zugeordnet. Bei vernetzten Systemen ist die jeweilige Priorität von dem Netz abhängig, an dem der zu der Takteinrichtung führende (Amts- oder Querverbindungs-) Satz angeschlossen ist, sowie von der Topologie des Fernmeldevermittlungssystems.

Die Einrichtung PE ermittelt in an sich bekannter Weise in Tabelle 3a aufgelistete Fehler "Takt nicht anschaltbar", "Bitschlupf (bit slip)", ^{"}Bitfehlerrate > 10 ^{-6"}, ^{"}Bitfehlerrate > 10 ^{-3"}, "Rahmenverlust" (lost frame), "kein Signal" (no signal). Die Bitfehlerraten werden mit Hilfe der CRC4-Prozedur nach CCITT G.704 bestimmt. Der Mikroprozessor MPC erkennt die Fehler "Takt nicht erkannt", "Regelung nicht möglich" und "wird nicht synchron".

Der Mikroprozessor MPC steuert den Schalter S insbesondere in der Weise, daß die Takteinrichtung bei unterschiedlichen Prioritäten (im vorliegenden Fall: Priorität der Referenztaktquelle A ist gleich 90, Priorität der Referenztaktquelle B ist gleich 89) das Referenztaktsignal f_{RA} der Referenztaktquelle A höchster Priorität übernimmt, sofern das von dieser Referenztaktquelle A zugeführte Referenztaktsignal f_{RA} einen (oberen) ersten Fehlergrenzwert nicht überschreitet. Bei einem Überschreiten dieses Fehlergrenzwertes, der beispielsweise auf den Wert 42.000 festgelegt wird, wird der Schalter S in der Weise gesteuert, daß die Takteinrichtung das Referenztaktsignal f_{RB} der Referenztaktquelle B nachgeordneter Priorität übernimmt, sofern das von dieser Referenztaktquelle B zugeführte Referenztaktsignal f_{RB} einen geringeren Fehlerwert als das Referenztaktsignal f_{RA} der Referenztaktquelle M höchster Priorität aufweist.

Für den Fall, daß Referenztaktquellen dieselbe Priorität aufweisen, schaltet der Mikroprozessor den Schalter S in der Weise, daß die Takteinrichtung das Referenztaktsignal mit geringerem taktfehlerindividuellen Fehlerwert übernimmt. Das erfindungsgemäße Verfahren ist sowohl auf Takteinrichtungen anwendbar, denen ausschließlich Referenztaktsignale von Referenztaktquellen gleicher Priorität zugeführt werden, als auch auf Takteinrichtungen, denen Referenztaktsignale von einer Mehrzahl von Referenztaktquellen zugeführt werden, wobei nur eine Untermenge der Referenztaktquellen die gleiche Priorität aufweist.

Wenn ein zur Synchronisation der Takteinrichtung angeschaltetes Referenztaktsignal unter einem unteren zweiten Fehlergrenzwert von beispielsweise 16000 liegt und damit einen relativ geringen aktuellen Fehlerwert aufweist, kann vorgesehen sein, daß das aktuell anliegende Referenztaktsignal auch dann beibehalten wird, wenn der aktuelle Fehlerwert eines nichtübernommenen Referenztaktsignals bzw. die aktuellen Fehlerwerte mehrerer nicht übernommener Referenztaktsignale einen gleichen oder geringeren aktuellen Fehlerwert als der aktuelle Fehlerwert des übernommenen Referenztaktsignals aufweisen. Damit haben die Prioritäten der Referenztaktquellen, die das von der Takteinrichtung übernommene bzw. die nichtübernommene Referenztaktsignale liefern, keinen Einfluß. Auf diese Weise wird, wie schon erwähnt, die Anzahl vorzunehmender Referenztaktwechsel vermindert.

Die zuvor beschriebenen Synchronisierverfahren werden durchgeführt, nachdem jedem der Takteinrichtung am Systemeingang von den Referenztaktquellen zugeführten Referenztaktsignal ein Anfangsfehlerwert zugeordnet ist.

Bei einer nach einem Systemausfall erfolgten Wiederinbetriebnahme des Systems wird das Synchronisationsverfahren ausgehend von den zum Zeitpunkt des Systemausfalls vorliegenden aktuellen Fehlerwerten fortsgesetzt. Hierzu ist der Tabellenspeicher TS beispielsweise als nichtflüchtiger Speicher ausgebildet. Die im Tabellenspeicher TS abgespeicherten aktuellen Fehlerwerte können jedoch auch in anderer Weise, wie noch beschrieben wird, gegen ein Löschen beim Systemausfall gesichert werden. Die aktuellen Fehlerwerte ergeben sich durch Addition der Anfangsfehlerwerte und der im laufenden Betrieb gebildeten taktfehlerindividuellen Werte. Die aktuellen Fehlerwerte können jedoch auch vermindert werden:

Der Mikroprozessor MPC oder eine separate Steuerung der Einrichtung PE vermindert die für die Referenztaktsignale gebildeten aktuellen Fehlerwerte nach Ablauf vorgegebener Zeiteinheiten um einen vorgegebenen Wert, beispielsweise um 5% pro Stunde. Eine Zeitzählung wird bei einem Systemausfall unterbrochen und bei einer Wiederinbetriebnahme fortgesetzt. Ebenso wird die Zeitzählung ab- bzw. unterbrochen, wenn ein ursprünglich dem System zugeführtes Referenztaktsignal ausfällt. Mit dieser zeitabhängigen Verminderung der Fehlerwerte wird der Einfluß aufgetretener Fehler nach Ablauf vorgegebener Zeiträume gemindert und der Einfluß der vorgegebenen Referenztaktquellenprioritäten erhöht.

Fig. 2 zeigt eine zentrale Takteinrichtung, an die in einem Fernmeldevermittlungssystem eine Mehrzahl referenztaktliefernder Baugruppen BG angeschaltet ist. Jede Baugruppe BG weist einen baugruppenindividuellen Prozessor MPB auf, der die aus der jeweiligen Baugruppe vorzunehmenden Steuervorgänge in Verbindung mit einem zentralen Datenprozessor DP und dem Prozessor MPC des zentralen Taktgenerators durchführt. Jede Baugruppe kann beispielsweise Amts- oder Querverbindungssätze SA und SB aufweisen. Die externen Referenztaktsignale, z.B. f_{RA} und f_{RB}, sind jeweils über einen Schalter der Sätze SA bzw. SB an den zentralen Taktgenerator CCGA anschaltbar. Taktfehler werden in den Baugruppen jeweils von einer Einheit PEB und im zentralen Taktgenerator von einer Einheit PEC ermittelt. Die Einrichtungen PEB und PEC entsprechen der in Fig. 1 dargestellten Einrichtung PE.

Ein Tabellenspeicher TS_{A} ist bei der vorliegenden Ausführungsform einem zentralen Datenprozessor DP_{A} zugeordnet. Der Tabellenspeicher TS_{A} und der zentrale Datenprozessor DP_{A} sind doppelt ausgeführt, so daß ein weiterer Tabellenspeicher TS_{B} und ein weiterer zentraler Datenprozessor DP_{B} vorgesehen ist. Die beiden Datenprozessoren DP_{A}, DP_{B} erkennen über eine sie verbindende Querleitung (cross channel) den Ausfall des Partnerprozessors. Erkennt ein (Stand by-) Prozessor den Ausfall des bisher aktiven Partnerprozessors, so startet der erstgenannte Prozessor einen Hochlauf. Wenn zuvor Änderungen des Inhalts des Tabellenspeichers, der dem aktiven Datenprozessor zugeordnet ist, in den Tabellenspeicher eingeschrieben werden, der dem Stand by-Datenprozessor zugeordnet ist, so kann der nun aktiv gewordene Datenprozessor sofort auf den aktuellen Datenstand in seinem zugeordneten Tabellenspeicher zugreifen und das aktuelle Referenztaktsignal anschalten.

Die beiden Tabellenspeicher TS_{A} und TS_{B} sind mit einer Festplatte HD (Hard Disc) verbunden. Es kann vorgesehen sein, daß ein dem gerade aktiven Datenprozessor DP_{A} oder DP_{B} zugeordnetes Programm veranlaßt, den Inhalt der Tabellenspeicher TS_{A} bzw. des Tabellenspeichers TS_{B}, der im Idealfall gleich dem Inhalt des Tabellenspeicher TS_{A} ist, beispielsweise in regelmäßigen Abständen oder bei Auftreten vorgegebener Ereignisse wie beispielsweise einem Referenztaktsignalwechsel in die nichtflüchtige Festspeicherplatte HD einzuschreiben, so daß bei einem Systemausfall die ursprünglich in den Speichern TS_{A} bzw. TS_{B} eingeschriebenen Daten erhalten bleiben. Bei Wiederinbetriebnahme des Systems wird der Inhalt des Speichers HD in die Tabellenspeicher TS_{A} und TS_{B} eingeschrieben. Damit erfolgt die Synchronisation nach einer Systemwiederinbetriebnahme auf der Grundlage der Daten, die zum Zeitpunkt der Systemausfalls in den Tabellenspeicher TS_{A} bzw. TS_{B} eingeschrieben waren. Damit entfallen wie bereits beschrieben, relativ lange Synchronisationsvorgänge, die sich bis zu einem relativ stabilen Zustand in der Größenordnung von Minuten oder Stunden erstrecken könnten.

Es kann auch alternativ zum Einschreiben der Daten in den Speicher HD vorgesehen sein, daß der bzw. die Tabellenspeicher TS_{A} und. TS_{B} als nichtflüchtige Speicher ausgebildet sind.

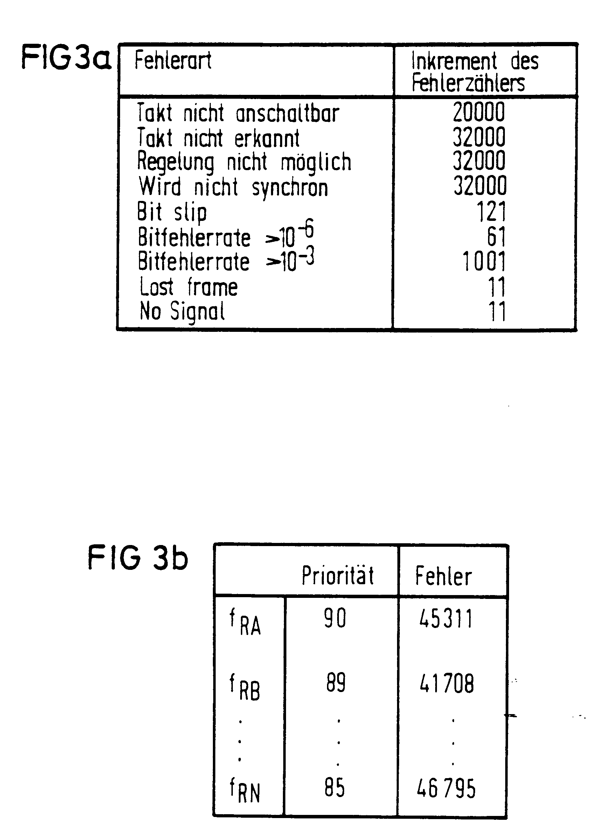

In Fig. 3a sind ausgewählte Fehlerarten und ihnen zugeordnete Fehlerwerte aufgelistet. Dabei bedeutet die Fehlerart "Takt nicht anschaltbar" , daß das Referenztaktsignal wegen einer am zugehörigen Eingang anliegenden Störung nicht angeschaltet werden kann. Der Mikroprozessor MPC bzw. MPB erkennt die Fehlerart "Takt nicht erkannt", wenn an dem gerade angeschalteten Eingang kein Referenztaktsignal anliegt. Ferner erkennt der mit dem internen Regelkreis verbundende Mikroprozessor MPC die Fehlerart "Regelung nicht möglich". Diese Fehlerart liegt z.B. vor, wenn der interne Regelkreis (PD, DAC, VCO, FD) des zentralen Takgenerators CCGA defekt ist oder nur eingeschränkt arbeitet. Ferner erkennt er die Fehlerart "wird nicht synchron", wenn es trotz an sich hinreichend lange Regelungszeiten nicht gelingt, die geforderte Synchronität zu dem angeschalteten Referenztaktsignal herzustellen.

Wie anhand der Fig. 1 und 2 beschrieben, ermitteln die Einrichtung PE bzw. PEB und PEC sowie MPC, MPB betriebsbegleitend das Auftreten von Fehlern und ordnet den Fehlern vorgegebene Fehlerwerte zu, die in Fig. 3a aufgelistet sind. Dabei kann vorgesehen sein, daß der in dem Tabellenspeicher TS (bzw. TS_{A}, TS_{B}) abgespeicherte referenztaktsignalindividuelle Fehlerzähler (Fig. 3b) bei Betriebsbeginn mit einem Fehlerwert 16.000 vorinitialisiert ist. Damit wird erreicht, daß bei der erfindungsgemäß vorgesehenen Verminderung des aktuellen Fehlerwertes nach Ablauf vorgegebener Zeiteinheiten um z.B. 5% pro Stunde der neugebildete Wert geringere, positive Werte als der Ausgangswert annehmen kann. Der Wert Null stellt den fehlerfreien Idealzustand dar.

Fig. 3b zeigt die im Tabellenspeicher TS (bzw. TS_{A}, TS_{B}) abgelegte Tabelle. In dieser sind für jede Referenztaktquelle die vorgegebene Priorität sowie der aktuelle Fehlerstand abgespeichert. Im dargestellten Beispiel beträgt der aktuelle Fehlerwert der Referenztaktquelle A höherer Priorität (90) 45.311, während der aktuelle Fehlerwert der Referenztaktquelle B geringerer Priorität (89) 41.708 beträgt. Für den Fall, daß als oberer Fehlergrenzwert 42.000 festgelegt wird, schaltet der Mikroprozessor MPC den Schalter S von dem Eingang, der das Referenztaktsignal f_{RA} führt, auf den Eingang um, der das Referenztaktsignal f_{RB} führt. Werden nun im Referenztaktsignal f_{RB} Taktfehler erkannt, die den Fehlerwert auf einen neuen Fehlerwert von z.B. 46.000 erhöhen, der oberhalb des dann aktuellen Fehlerwerts von f_{RA} = 45.311 liegt, so schaltet der Mikroprozessor MPC den Schalter S wiederum auf den Eingang um, der das Referenztaktsignal f_{RA} führt.

Bei dem erfindungsgemäßen Verfahren wird, wie bereits beschrieben jedem der Takteinrichtung von den Referenztaktquellen zugeführten Referenztaktsignal f_{RA}, f_{RB}; ... f_{RN} bei einer Erstinbetriebnahme des Fernmeldevermittlungssystems je ein Anfangswert zugeordnet, beispielsweise 16000. Im laufenden Betrieb des Fernmeldevermittlungssystems wird jedes Referenztaktsignal f_{RA}, f_{RB}, ... f_{RN} auf referenztaktsignalindividuelle Taktfehler (Fig. 3a) überprüft, denen taktindividuelle Fehlerwerte zugeordnet werden. Die Takteinrichtung übernimmt zu ihrer Synchronisation eines der Referenztaktsignale in Abhängigkeit der der Referenztaktquellen zugeordneten Prioritäten und in Abhängigkeit von aus den Anfangsfehlerwerten und den taktfehlerindividuellen Fehlerwerten gebildeten aktuellen Fehlerwerten. Bei einer nach einem Systemausfall erfolgten Wiederinbetriebnahme des Systems wird das Synchronisationverfahren ausgehend von den zum Zeitpunkt des Systemausfalls vorliegenden aktuellen Fehlerwert fortgesetzt. Dabei kann vorgesehen sein, daß bei einer Wiederinbetriebnahme des Systems, die nach Ablauf einer vorgegebenen Zeiteinheit nach dem Systemausfall erfolgt, die Synchronisation ausgehend von den Anfangsfehlerwerten neu begonnen wird.

Weiterhin kann die Synchronisation in der Weise erfolgen, daß die Takteinrichtung nach der Erstinbetriebnahme und nach der Wiederinbetriebnahme bei gleichen Prioritäten der Referenztaktquellen das Referenztaktsignal mit geringeren taktfehlerindividuellen Fehlerwert übernimmt. Bei unterschiedlichen Prioritäten der Referenztaktquellen übernimmt die Takteinrichtung des Referenztaktsignal der Referenztaktquelle höchster Priorität, sofern das von dieser Referenztaktquelle zugeführten Referenztaktsignal einen vorgegebenen oberen Fehlergrenzwert, beispielsweise 42000, nicht überschreitet. Bei einem Überschreiten dieses oberen ersten Fehlergrenzwertes übernimmt die Takteinrichtung des Referenztaktsignal einer Referenztaktquelle nachgeordneter Priorität, sofern das von dieser Referenztaktquelle zugeführte Referenztaktsignal einen geringeren aktuellen Fehlerwert als das Referenztaktsignal der Referenztaktquelle höchster Priorität aufweist.

Die Takteinrichtung behält zu ihrer Synchronisation nach der Erstinbetriebnahme oder nach der Wiederinbetriebnahme des Systems bei gleichen oder unterschiedlichen Prioritäten der Referenztaktquellen das von der momentan aktivierten Referenztaktquelle abgegebene Referenztaktsignal auch dann, wenn der Fehlerwert dieses Referenztaktsignals unter einem unteren, zweiten Fehlergrenzwert von beispielsweise 16000 liegt und der aktuelle Fehlerwert des oder der anderen Referenztaktsignale einen gleichen oder geringeren aktuellen Wert aufweisen.

Das Fernmeldesystem kann in der Weise ausgestaltet sein, daß bei einer Wiederinbetriebnahme des Systems die Sätze SA, SB referenztaktliefernder Baugruppen BG einzeln nacheinander in Betrieb genommen werden. Dabei wird mittels im System abgespeicherter Daten bei jeder Inbetriebnahme eines Satzes geprüft, ob dieser Satz zum Zeitpunkt des Systemausfalls eine externe Referenztaktleitung (an den in Fig. 1 und in Fig. 2 dargestellten Systemeingängen, die mit f_{RA} und f_{RB} bezeichnet sind) zur zentralen Takteinrichtung CCGA durchgeschaltet hatten. Ergibt diese Prüfung ein positives Ergebnis, hatte also der gerade wiederinbetriebgenommene Satz zum Zeitpunkt des Systemausfalls eine externe Referenztaktleitung durchgeschaltet, so wird diese externe Referenztaktleitung wiederum zur zentralen Takteinrichtung CCGA durchgeschaltet. Damit kann die Durchschaltung der externen Referenztaktleitung an die zentrale Takteinrichtung zu einen Zeitpunkt erfolgen, zu dem noch weitere Sätze des Fernmeldevermittlungssystems wieder in Betrieb genommen werden. Je nach Systemgröße ergibt sich damit eine Zeitersparnis, die in der Größenordnung von Minuten liegt. Nach dieser Anschaltung der externen Referenztaktleitung bei der Wiederinbetriebnahme eines einzelnen Satzes überprüft die zentrale Takteinrichtung, insbesondere der Mikroprozessor MPC, wie zuvor beschrieben, ob die Fehlerfälle "Takt nicht erkannt", "Regelung nicht möglich" und "wird nicht synchron" vorliegen.

## Patentansprüche

1. Verfahren zur Synchronisation einer Takteinrichtung (CCGA) eines Fernmeldevermittlungssystems, der zumindestens zeitweise von einer Mehrzahl externer Referenztaktquellen (A, B, ... N) Referenztaktsignale (f_{RA}, f_{RB}, ... f_{RN}) zugeführt werden, **dadurch gekennzeichnet,**
daß jeder externen Referenztaktquelle (A, B, ... N) eine vorgegebene Priorität zugeordnet ist, daß jedem der Takteinrichtung (CCGA) von den Referenztaktquellen (A, B, ... N) zugeführten Referenztaktsignal (f_{RA}, f_{RB}, ... f_{RN}) bei einer Erstinbetriebnahme des Fernmeldevermittlungssystems je ein Anfangsfehlerwert zugeordnet ist, daß im laufenden Betrieb des Fernmeldevermittlungssystems jedes Referenztaktsignal (f_{RA}, f_{RB}, ... f_{RN}) auf referenztaktsignalindividuelle Taktfehler überprüft wird, denen taktfehlerindividuelle Fehlerwerte zugeordnet werden, daß die Takteinrichtung (CCGA) zu ihrer Synchronisation eines der Referenztaktsignale (f_{RA}, f_{RB}, ... f_{RN}) in Abhängigkeit der den Referenztaktquellen (A, B, ... N) zugeordneten Prioritäten und in Abhängigkeit von aus den Anfangsfehlerwerten und den taktfehlerindividuellen Fehlerwerten gebildeten aktuellen Fehlerwerten übernimmt, daß die Takteinrichtung (CCGA) bei einer nach einem Ausfall des Fernmeldevermittlungssystems erfolgten Wiederinbetriebnahme des Fernmeldevermittlungssystems das Synchronisationsverfahren ausgehend von den zum Zeitpunkt des Systemausfalls vorliegenden aktuellen Fehlerwerten fortsetzt.

2. Verfahren nach Anspruch 1,
**dadurch gekennzeichnet,**
daß bei einer Wiederinbetriebnahme des Fernmeldevermittlungssystems, die nach Ablauf einer vorgegebenen Zeiteinheit nach dem Systemausfall erfolgt, die Synchronisation ausgehend von den Anfangsfehlerwerten neu begonnen wird.

3. Verfahren nach Anspruch 1 oder 2,
**dadurch gekennzeichnet,**
daß die Takteinrichtung (CCGA) zu ihrer Synchronisation nach der Erstinbetriebnahme und nach der Wiederinbetriebnahme bei gleichen Prioritäten der Referenztaktquellen (A,B) das Referenztaktsignal (f_{RA}, f_{RB}) mit geringerem taktfehlerindividuellen aktuellen Fehlerwert übernimmt, und daß die Takteinrichtung (CCGA) bei unterschiedlichen Prioritäten der Referenztaktquellen (A,B) das Referenztaktsignal (f_{RA}, f_{RB}) der Referenztaktquelle (A) höchster Priorität übernimmt, sofern das von dieser Referenztaktquelle (A) zugeführte Referenztaktsignal (f_{RA}) einen vorgegebenen oberen ersten Fehlergrenzwert nicht überschreitet, und daß bei einem Überschreiten dieses Fehlergrenzwertes die Takteinrichtung das Referenztaktsignal (f_{RB}) der Referenztaktquelle (B) nachgeordneter Priorität übernimmt, sofern das von der Referenztaktquelle (B) nachgeordneter Priorität zugeführte Referenztaktsignal (f_{RB}) einen geringeren aktuellen Fehlerwert als das Referenztaktsignal (f_{RA}) der Referenztaktquelle (A) höchster Priorität aufweist.

4. Verfahren nach einem der vorstehenden Ansprüche,
**dadurch gekennzeichnet,**
daß die Takteinrichtung (CCGA) zu ihrer Synchronisation nach der Erstinbetriebnahme oder nach der Wiederinbetriebnahme des Fernmeldevermittlungssystems bei gleichen oder unterschiedlichen Prioritäten der Referenztaktquellen (A,B) das von der momentan aktivierten Referenztaktquelle (B,A) abgegebene Referenztaktsignal (f_{RB}, f_{RA}) auch dann beibehält, wenn der aktuelle Fehlerwert dieses Referenztaktsignals unter einem unteren, zweiten Fehlergrenzwert liegt und der aktuelle Fehlerwert des oder der anderen Referenztaktsignale einen gleichen oder geringeren aktuellen Wert aufweisen.

5. Verfahren nach einem der vorstehenden Ansprüche,
**dadurch gekennzeichnet,**
daß die aktuellen Fehlerwerte, die den der Takteinrichtung (CCGA) zugeführten Referenztaktsignalen (f_{RA}, f_{RB}) zugeordnet sind nach Ablauf vorgegebener Zeiteinheiten um einen vorgegebenen Wert vermindert werden.

6. Verfahren nach einem der vorstehenden Ansprüche,
**dadurch gekennzeichnet,**
daß bei einer Wiederinbetriebnahme des Fernmeldevermittlungssystems Sätze (SA, SB) referenztaktliefernder Baugruppen (BG), nacheinander in Betrieb genommen werden, daß bei jeder Inbetriebnahme eines Satzes(SA, SB) geprüft wird, ob dieser Satz (SA, SB) zum Zeitpunkt des Systemausfalls eine externe Referenztaktleitung zur zentralen Takteinrichtung (CCGA) durchgeschaltet hatte, und daß nach einem positiven Ergebnis dieser Prüfung die externe Referenztaktleitung zur zentralen Takteinrichtung (CCGA) durchgeschaltet wird.

7. Vorrichtung zur Durch führung eines Verfahrens nach einem der vorhergehenden Ansprüche, mit einer Takteinrichtung (CCGA) und einer Mehrzahl externer Referenztaktquellen (A, B,..., n) zur Zuführung von Referenztaktsignalen (f_{RA}, f_{RB}), wobei von einer Steuerung (MPC, DP) jeder externen Referenztaktquelle eine Priorität und jedem Referenztaktsignal (f_{RA}, f_{RB}) bei einer Erstinbetriebnahme je ein Anfangsfehlerwert zugeordnet ist, mit einem Tabellenspeicher (TS) zur Speicherung der Priorität und der Fehlerwerte für jedes Referenztaktsignal und mit einer Einrichtung (PE) zur Überprüfung der zugeführten Referenztaktsignale im laufenden Betrieb auf referenztaktsignalindividuelle Taktfehler für die von der Steuerung eine Zuordnung zu taktfehlerindividuellen Fehlerwerten für eine Korrektur der im Tabellenspeicher (TS) gespeicherten Fehlerwerte vorgesehen ist, und mit einer Programmierung der Steuerung derart, daß in Abhängigkeit der den Referenztaktquellen zugeordneten Prioritäten und in Abhängigkeit der in dem Tabellenspeicher gespeicherten aktuellen Fehlerwerten eines der Referenztaktsignale ausgewählt wird und bei einer nach einem Ausfall erfolgten Wiederinbetriebnahme die zum Zeitpunkt des Ausfalls vorliegenden aktuellen Fehlerwerte als Anfangsfehlerwerte behandelt werden.

8. Vorrichtung nach Anspruch 7,
**dadurch gekennzeichnet,**
daß die Steuerung (DP_{A}, DP_{B}) und/oder der Tabellenspeicher (TS_{A}, TS_{B}) gedoppelt sind.

## Claims

1. Method of synchronizing a clock circuit (CCGA) of a telecommunications switching system, which is supplied at least from time to time with reference clock signals (f_{RA}, f_{RB}, ... f_{RN}) from a plurality of external reference clock sources (A, B, ... N), characterized in that a predetermined priority is allocated to each external reference clock source (A, B, ... N), in that an initial error value is in each case allocated to each reference clock signal f_{RA}, f_{RB}... f_{RN}) supplied to the clock circuit (CCGA) from the reference clock sources (A, B, ... N) on initial commissioning of the telecommunications switching system, in that, during the operation of the telecommunications switching system, each reference clock signal (f_{RA}, f_{RB}, ... f_{RN}) is checked for reference-clock-signal-individual clock errors to which clock-error-individual error values are allocated, in that the clock circuit (CCGA) accepts for its synchronization one of the reference clock signals f_{RA}, f_{RB} ... f_{RN}) in dependence on the priorities allocated to the reference clock sources (A, B, ... N) and in dependence on current error values formed from the initial error values and the clock-error-individual error values, in that the clock circuit (CCGA), in a return to service of the telecommunications switching system after an outage of the telecommunications switching system, continues the synchronization process starting with the current error values present at the time of the system outage.

2. Method according to Claim 1, characterized in that, in a return to service of the telecommunications switching system after a predetermined unit of time has elapsed after the system outage, the synchronization is restarted starting with the initial error values.

3. Method according to Claim 1 or 2, characterized in that the clock circuit (CCGA) accepts the reference clock signal (f_{RA}, f_{RB}) with lower clock-error-individual current error value for its synchronization after the initial commissioning and after the return to service, when the reference clock sources (A, B) have the same priorities, and in that the clock circuit (CCGA) accepts the reference clock signal (f_{RA}, f_{RB}) of the reference clock source (A) with the highest priority in the case of different priorities of the reference clock sources (A, B), if the reference clock signal (f_{RA}) supplied from this reference clock source (A) does not exceed a predetermined upper first error limit value, and in that, when this error limit value is exceeded, the clock circuit accepts the reference clock signal (f_{RB}) of the reference clock source (B) with the lower priority if the reference clock signal (f_{RB}) supplied from the reference clock source (B) with the lower priority has a lower current error value than the reference clock signal (f_{RA}) of the reference clock source (A) with the highest priority.

4. Method according to one of the preceding claims, characterized in that the clock circuit (CCGA) retains the reference clock signal (f_{RB}, R_{RA}) output by the currently activated reference clock source (B, A) for its synchronization after initial commissioning or after the return to service of the telecommunications switching system in the case of equal or different priorities of the reference clock sources (A, B), even if the current error value of this reference clock signal is below a lower second error limit value and the current error value of the other reference clock signal or signals exhibits an equal or lower current value.

5. Method according to one of the preceding claims, characterized in that the current error values which are allocated to the reference clock signals (f_{RA}, f_{RB}) supplied to the clock circuit (CCGA) are reduced by a predetermined value after predetermined units of time have elapsed.

6. Method according to one of the preceding claims, characterized in that, in a return to service of the telecommunications switching system, circuits (SA, SB) of reference-clock-supplying assemblies (BG) are successively taken into operation, in that each time a circuit (SA, SB) is taken into operation, a check is made whether this circuit (SA, SB) had switched an external reference clock line through to the central clock circuit (CCGA) at the time of the system outage and in that, after a positive result of this check, the external reference clock line is switched through to the central clock circuit (CCGA).

7. Device for carrying out a method according to one of the preceding claims, with a clock circuit (CCGA) and a plurality of external reference clock sources (A, B, ... N) for supplying reference clock signals (f_{RA}, f_{RB}), a controller (MPC, DP) allocating a priority to each external reference clock source and in each case an initial error value to each reference clock signal (f_{RA}, f_{RB}) on initial commissioning, with a table memory (TS) for storing the priority and the error values for each reference clock signal and with a device (PE) for checking the supplied reference clock signals in operation for reference-clock-signal-individual clock errors for which the controller has provided an allocation to clock-error- individual error values for a correction of the error values stored in the table memory (TS), and with programming of the controller in such a manner that one of the reference clock signals is selected in dependence on the priorities allocated to the reference clock sources and in dependence on the current error values stored in the table memory, and in a return to service after an outage, the current error values present at the time of the outage are treated as initial error values.

8. Device according to Claim 7, characterized in that the controller (DP_{A}, DP_{B}) and/or the table memory (TS_{A}, TS_{B}) are duplicated.

## Revendications

1. Procédé de synchronisation d'un dispositif de cadence (CCGA) d'un système de commutation de télécommunication, auquel des signaux de cadence de référence (f_{RA}, f_{RB}, ... f_{RN}) sont envoyés, au moins temporairement, par une multiplicité de sources externes de cadence de référence (A, B, ... N),
caractérisé en ce qu'à chaque source externe de cadence de référence (A, B, ... N) on associe une priorité prédéterminée, qu'à chaque signal de cadence de référence (f_{RA}, f_{RB}, ... f_{RN}), qui est envoyé au dispositif de cadence (CCGA) par les sources de cadence de référence (A, B, ... N), on associe une valeur de défaut initial, lors d'une première mise en fonctionnement du système de commutation de télécommunication, qu'au cours du fonctionnement du système de commutation de télécommunication, on contrôle chaque signal de cadence de référence (f_{RA}, f_{RB}, ... f_{RN}) du point de vue des défauts de cadence propres au signal de cadence de référence, auxquels sont associées des valeurs de défaut, propres aux défauts de cadence, que l'on transmet, par le dispositif de cadence (CCGA), au cours de sa synchronisation, un des signaux de cadence de référence (F_{RA}, f_{RB}, ..., f_{RN}) en fonction des priorités associées aux sources de cadence de référence (A, B, ... N) et en fonction des valeurs de défauts réelles et formées à partir des valeurs de défaut initial et à partir des valeurs de défauts propres aux défauts de cadence, que, lors d'une nouvelle mise en fonctionnement du système de commutation de télécommunication effectuée après une défaillance du système de commutation de télécommunication, on continue à effectuer, par le dispositif de cadence (CCGA), le procédé de synchronisation en fonction des valeurs de défauts réelles présentes à l'instant de la défaillance du système.

2. Procédé suivant la revendication 1,
caractérisé en ce que, lors d'une nouvelle mise en fonctionnement du système de commutation de télécommunication, qui s'effectue après qu'une unité de temps prédéterminée s'est écoulée après la défaillance du système, on commence à nouveau la synchronisation des valeurs de défaut initial.

3. Procédé suivant la revendication 1 ou 2,
caractérisé en ce que l'on transmet, par le dispositif de cadence (CCGA), au cours de sa synchronisation, après la première mise en fonctionnement et après la nouvelle mise en fonctionnement, pour des priorités identiques des sources de cadence de référence (A, B), le signal de cadence de référence (f_{RA}, f_{RB}) avec la plus faible valeur de défaut réelle et propre au défaut de cadence, et que l'on transmet, par le dispositif de cadence (CCGA), pour différentes priorités des sources de cadence de référence (A, B), le signal de cadence de référence (f_{RA}, f_{RB}) de la source de cadence de référence (A) de plus haute priorité, tant que le signal de cadence de référence (f_{RA}) envoyé par cette source de cadence de référence (A) ne dépasse pas une première valeur limite de défaut supérieure prédéterminée, et que, lors d'un dépassement de cette valeur limite de défaut, on transmet, par le dispositif de cadence, le signal de cadence de référence (f_{RB}) de la source de cadence de référence (B) de priorité suivante, tant que le signal de cadence de référence (f_{RB}), envoyé par la source de cadence de référence (B) de priorité suivante, présente une valeur de défaut réelle plus faible que celle du signal de cadence de référence (f_{RA}) la source de cadence de référence (A) de plus haute priorité.

4. Procédé suivant l'une des revendications précédentes,
caractérisé en ce que l'on maintient, par le dispositif de cadence (CCGA), lors de sa synchronisation, après la première mise en fonctionnement ou après la nouvelle mise en fonctionnement du système de commutation de télécommunication, et pour des priorités identiques ou différentes des sources de cadence de référence (A, B), le signal de cadence de référence (f_{RB}, f_{RA}) fourni par la source de cadence de référence active momentanément (B, A), également lorsque la valeur de défaut réelle de ce signal de cadence de référence est en-dessous d'une deuxième valeur limite inférieure de défaut et lorsque la valeur de défaut réelle du ou des autres signaux de cadence de référence présente une valeur réelle égale ou plus petite.

5. Procédé suivant l'une des revendications précédentes,
caractérisé en ce qu'après que des unités de temps prédéterminées se soient écoulées, on diminue d'une valeur prédéterminée les valeurs de défauts réelles, qui sont associées aux signaux de cadence de référence (f_{RA}, f_{RB}) envoyés au dispositif de cadence (CCGA).

6. Procédé suivant l'une des revendications précédentes,
caractérisé en ce que, lors d'une nouvelle mise en fonctionnement du système de commutation de télécommunication, on met en fonctionnement les uns après les autres des ensembles (SA, SB) de modules (BG) fournissant des cadences de référence, que, lors de chaque mise en fonctionnement d'un ensemble (SA, SB) , on contrôle s'il a interconnecté, à l'instant de la défaillance du système, une ligne externe de cadence de référence au dispositif central de cadence (CCGA), et que, suivant un résultat positif de ce contrôle, on interconnecte la ligne externe de cadence de référence au dispositif central de cadence (CCGA).

7. Dispositif pour la mise en oeuvre d'un procédé suivant l'une des revendications précédentes, comportant un dispositif de cadence (CCGA) et une mulitiplicité de sources externes de cadence de reference (A, B, ..., n) pour l'envoi de signaux de cadence de référence (f_{RA}, f_{RB}), une priorité étant associée, par une unité de commande (MPC, DP), à chaque source externe de cadence de référence, et une valeur de défaut initial étant associée, lors d'une première mise en fonctionnement, à chaque signal de cadence de référence (f_{RA}, f_{RB}), et comportant une mémoire de tableaux (TS) destinée à la mémorisation de la priorité et des valeurs de défaut pour chaque signal de cadence de référence, et comportant un dispositif (PE) de contrôle, au cours du fonctionnement, des signaux de cadence de référence envoyés, du point de vue du défaut de cadence propre à chaque signal de cadence de référence, pour lesquels il est prévu, par l'intermédiaire de l'unité de commande, une association à des valeurs de défaut propres aux défauts de cadence, pour une correction des valeurs de défauts mémorisées dans la mémoire de tableaux (TS), et comportant une unité de programmation de l'unité de commande, de telle sorte qu'en fonction des priorités associées aux sources de cadence de référence et en fonction des valeurs de défauts réelles mémorisées dans la mémoire de tableaux, un des signaux de cadence de référence est sélectionné et, lors d'une nouvelle mise en fonctionnement effectuée après une défaillance, les valeurs de défauts réelles presentes à l'instant de la défaillance, sont traitées en tant que valeurs de défaut initial.

8. Dispositif suivant la revendication 7,
caractérisé en ce que l'unité de commande (DP_{A}, DP_{B}) et/ou la mémoire de tableaux (TS_{A}, TS_{B}) sont doublées.
